# EUROPÄISCHE PATENTSCHRIFT

(11) **EP 2 030 261 B1**
(45) Veröffentlichungstag und Bekanntmachung des Hinweises auf die Patenterteilung: **26.12.2012**
(21) Anmeldenummer: 07729388.4
(22) Anmeldetag: 22.05.2007
(51) Int. Cl.: H01L 41/047, H01L 41/083, F02M 51/06

(54) **PIEZOELEKTRISCHER AKTOR**
PIEZOELECTRIC ACTUATOR
ACTIONNEUR PIÉZOÉLECTRIQUE

(30) Priorität: 08.06.2006 DE 102006026643
(43) Veröffentlichungstag der Anmeldung: 04.03.2009
(73) Patentinhaber: Robert Bosch GmbH, 70442 Stuttgart (DE)
(72) Erfinder: BOECKING, Friedrich, 70499 Stuttgart (DE)
(86) Internationale Anmeldenummer: PCT/EP2007/054949
(87) Internationale Veröffentlichungsnummer: WO 2007/141137

(56) Entgegenhaltungen:
- EP-A- 1 814 170
- WO-A-00/79608
- WO-A-01/91199
- DE-A1- 3 223 801
- DE-A1- 10 163 358

## Beschreibung

### Stand der Technik

Die Erfindung betrifft einen piezoelektrischen Aktor für ein Brennstoffeinspritzventil und ein Brennstoffeinspritzventil mit solch einem piezoelektrischen Aktor. Speziell betrifft die Erfindung das Gebiet der Injektoren für Brennstoffeinspritzanlagen von luftverdichtenden, selbstzündenden Brennkraftmaschinen.

Aus der DE 199 28 189 A1 ist ein Piezoaktor zur Betätigung eines Ventils bekannt. Der bekannte Piezoaktor weist Außenelektroden auf, bei denen eine erste Schicht der Außenelektrode durch eine Metallfläche und eine zweite Schicht der Außenelektrode als netz- oder gewebeartige Schicht ausgestaltet ist. Die Verbindung der beiden Schichten erfolgt beispielsweise punktweise, wobei zwischen den Kontaktierungen ein dehnbarer Bereich zu liegen kommt. Die netz- oder gewebeartige Außenelektrodenschicht dient zur Vermeidung von Querrissen, die von den Innenelektroden durch Delamination auftreten können, wobei durch die punktuelle Anlötung keine großen Schubspannungen bei der Dehnung des Piezoaktors in den Außenelektroden entstehen.

Der aus der DE 199 28 189 A1 bekannte Piezoaktor hat den Nachteil, dass sich die bei einer Dehnung des Piezoaktors in der Außenelektrode auftretenden Spannungen auf wenige Kontaktstellen aufteilen, so dass auf Grund der hohen Belastung der Kontaktstellen eine Beschädigung dieser möglich ist. Ferner ist die Ausgestaltung der Außenelektroden des bekannten Piezoaktors aufwändig und daher mit hohen Herstellungskosten verbunden.

WO 01/91199 A1 offenbart einen Piezoaktor, dessen Außenelektroden netz- oder gewebeartig auf jeweils einer Seitenfläche verteilt aufgebracht sind und zumindest punktweise mit den jeweiligen Innenelektroden kontaktiert sind.

Das Netz besteht aus gekneuzten drähten mit Kontaktstellen, wobei die Drähte in Längs- und Querrichtung des Piezostapels verlaufen.

### Offenbarung der Erfindung

### Vorteilhafte Wirkungen

Der erfindungsgemäße piezoelektrische Aktor mit den Merkmalen des Anspruchs 1 und das erfindungsgemäße Brennstoffeinspritzventil mit den Merkmalen des Anspruchs 13 haben demgegenüber den Vorteil, dass eine zuverlässige Kontaktierung zwischen der Außenelektrode und den keramischen Schichten gegeben und eine kostengünstige Herstellung möglich ist.

Durch die in den Unteransprüchen aufgeführten Maßnahmen sind vorteilhafte Weiterbildungen des im Anspruch 1 angegebenen piezoelektrischen Aktors und des im Anspruch 13 angegebenen Brennstoffeinspritzventils möglich.

Vorteilhaft ist es, dass die Längsdrähte nebeneinander verlaufen und dass der Schussdraht so durch die Längsdrähte geführt ist, dass von jeweils zwei nebeneinander verlaufenden Längsdrähten einer oberhalb und ein anderer unterhalb des Schussdrahtes verläuft. Dabei können die Längsdrähte als schlangenförmig Längsdrähte ausgestaltet sein, wobei die Schussdrähte erfindungs-gemäβ als näherungsweise gerade Schussdrähte ausgebildet sind. Dies hat den Vorteil, dass eine relativ dichte, webartige Struktur der Außenelektrode erreicht wird, die in Längsrichtung dehnbar ist, die hohen Spannungen standhält und die eine zuverlässige Verbindung mit den Elektrodenschichten des Aktorkörpers ermöglicht.

Ferner ist es vorteilhaft, dass die Schussdrähte einen größeren Durchmesser aufweisen als die Längsdrähte, wobei der Durchmesser der Schussdrähte vorzugsweise das x-Fache des Durchmessers der Längsdrähte mit x größer als 1,0 und kleiner oder gleich 3 ist. Bei dieser Ausgestaltung schlingen sich dünne, flexible und als Hubdrähte ausgestaltete Längsdrähte um relativ steif ausgestaltete Schussdrähte, so dass sich eine flexible Struktur der Außenelektrode ergibt, die hohen Belastungen standhält.

Die Längsdrähte und die Schussdrähte können aus den gleichen oder auch aus verschiedenen Werkstoffen ausgebildet sein. Vorzugsweise sind die Schussdrähte aus Messing, Kupfer, Silber oder einer Kombination dieser Werkstoffe hergestellt, während die Längsdrähte vorzugsweise aus einer Invarlegierung hergestellt sind. Eine solche Invarlegierung kann beispielsweise aus einem Stahl mit einem Anteil von 36 % Nickel hergestellt sein, so dass sich die Längsdrähte beim Erwärmen nicht beziehungsweise fast nicht ausdehnen.

Die Schussdrähte können in einer Querrichtung, das heißt senkrecht zur Längsrichtung, verlaufen oder in Bezug auf die Querrichtung auch unter einem gewissen Winkel durch die Längsdrähte geführt sein, so dass die Schussdrähte in einer Richtung verlaufen, die mit der Längsrichtung einen Winkel einschließt, der größer als 0° und kleiner als 90° ist.

Die aus den Längs- und den Schussdrähten gebildete Struktur der Außenelektrode kann auf geeignete Weise mit den Elektrodenschichten des Aktorkörpers, insbesondere durch Löten, verbunden sein. Diese Lötverbindung kann dabei relativ großflächig ausgestaltet sein und ist nicht notwendigerweise auf wenige Kontaktpunkte beschränkt, wobei die Flexibilität der Außenelektrode in Bezug auf die beim Betätigen des Aktors erfolgende Dehnung des Aktorkörpers durch die flexible Struktur gewährleistet ist.

### Kurze Beschreibung der Zeichnungen

Bevorzugte Ausführungsbeispiele der Erfindung sind in der nachfolgenden Beschreibung anhand der beigefügten Zeichnungen, in den sich entsprechende Elemente mit übereinstimmenden Bezugszeichen versehen sind, näher erläutert. Es zeigt:
Fig. 1 ein Brennstoffeinspritzventil mit einem piezoelektrischen Aktor in einer schematischen Schnittdarstellung entsprechend einem ersten Ausführungsbeispiel der Erfindung;
Fig. 2 den in Fig. 1 mit II bezeichneten Ausschnitt des piezoelektrischen Aktors des Brennstoffeinspritzventils des ersten Ausführungsbeispiels der Erfindung;
Fig. 3 eine auszugsweise Darstellung eines piezoelektrischen Aktors eines Brennstoffeinspritzventils gemäß dem ersten Ausführungsbeispiel der Erfindung aus der in Fig. 2 mit I bezeichneten Blickrichtung und
Fig. 4 den in Fig. 3 dargestellten Ausschnitt eines piezoelektrischen Aktors eines Brennstoffeinspritzventils gemäß einem zweiten Ausführungsbeispiel der Erfindung.

### Ausführungsformen der Erfindung

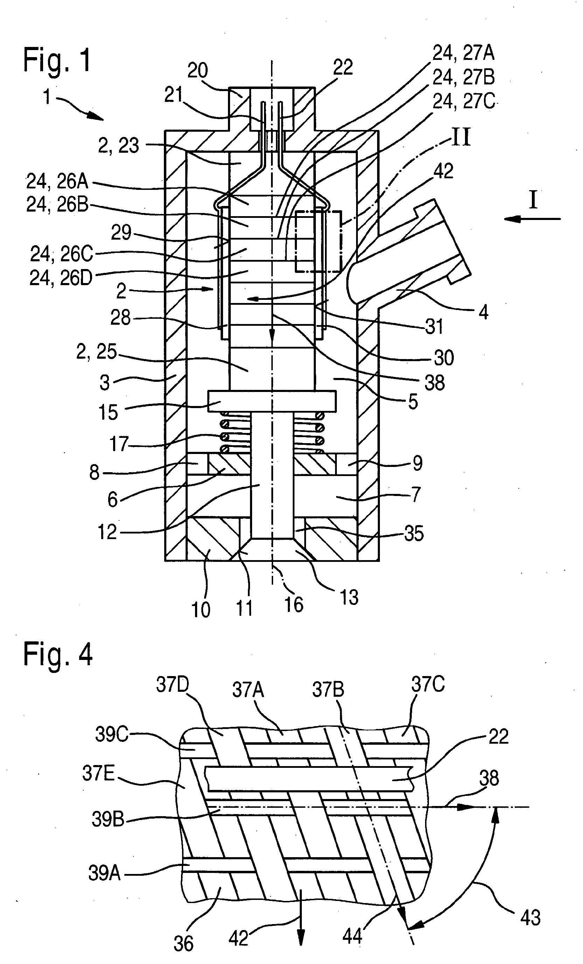

Fig. 1 zeigt ein Brennstoffeinspritzventil 1 mit einem piezoelektrischen Aktor 2 entsprechend einem ersten Ausführungsbeispiel der Erfindung. Das Brennstoffeinspritzventil 1 kann insbesondere als Injektor für Brennstoffeinspritzanlagen von gemischverdichtenden, selbstzündenden Brennkraftmaschinen dienen. Ein bevorzugter Einsatz des Brennstoffeinspritzventils 1 besteht für eine Brennstoffeinspritzanlage mit einem Common-Rail, das Dieselbrennstoff unter hohem Druck zu mehreren Brennstoffeinspritzventilen 1 führt. Der erfindungsgemäße piezoelektrische Aktor 2 eignet sich besonders für solch ein Brennstoffeinspritzventil 1. Das erfindungsgemäße Brennstoffeinspritzventil 1 und der erfindungsgemäße Aktor 2 eignen sich jedoch auch für andere Anwendungsfälle.

Das Brennstoffeinspritzventil 1 weist ein Ventilgehäuse 3 mit einem Brennstoffeinlassstutzen 4 auf. An den Brennstoffeinlassstutzen 4 ist eine Brennstoffleitung anschließbar, um Brennstoff in einen im Inneren des Ventilgehäuses 3 vorgesehenen Aktorraum 5 einzuleiten. Der Aktorraum 5 ist durch ein Gehäuseteil 6 von einem ebenfalls im Inneren des Ventilgehäuses 3 vorgesehenen Brennstoffraum 7 getrennt, wobei das Gehäuseteil 6 Durchlassöffnungen 8, 9 aufweist, um den zugeführten Brennstoff über den Aktorraum 5 in den Brennstoffraum 7 zu leiten.

An einem Ventilsitzkörper 10, der mit dem Ventilgehäuse 3 verbunden ist, ist eine Ventilsitzfläche 11 ausgebildet, die mit einem von dem piezoelektrischen Aktor 2 mittels einer Ventilnadel 12 betätigbaren Ventilschließkörper 13 zu einem Dichtsitz zusammenwirkt. Dabei ist der Ventilschließkörper 13 über die Ventilnadel 12 mit einer Druckplatte 15 verbunden, die innerhalb des Aktorraums 5 angeordnet ist. Ferner ist die Ventilnadel 12 durch das Gehäuseteil 6 in axialer Richtung, das heißt in Richtung einer Achse 16 des Ventilgehäuses 3 des Brennstoffeinspritzventils 1, geführt. Innerhalb des Aktorraums 5 ist außerdem eine Ventilfeder 16 vorgesehen, die den Ventilschließkörper 13 über die Druckplatte 15 und die Ventilnadel 12 mit einer Schließkraft beaufschlagt, so dass der zwischen dem Ventilschließkörper 13 und der Ventilsitzfläche 11 gebildete Dichtsitz geschlossen ist.

An den Ventilgehäuse 3 ist außerdem ein Anschlusselement 20 ausgebildet, um das Brennstoffeinspritzventil 1 an eine elektrische Zuleitung anzuschließen, wobei die elektrische Zuleitung mittels eines Steckers mit elektrischen Leitungen 21, 22 verbunden werden kann. Die elektrischen Leitungen 21, 22 sind durch das Ventilgehäuse 3 und einen Aktorfuß 23 des Aktors 2 zu einem Aktorkörper 24 des Aktors 2 geführt. Ferner weist der Aktor 2 einen Aktorkopf 25 auf.

Der Aktorkörper 24 des piezoelektrischen Aktors 2 weist eine Vielzahl von keramischen Schichten 26A, 26B, 26C, 26D und eine Vielzahl von zwischen den keramischen Schichten 26A bis 26D angeordneten Elektrodenschichten 27A, 27B, 27C auf. Dabei sind zur Vereinfachung der Darstellung nur die keramischen Schichten 26A bis 26D sowie die Elektrodenschichten 27A bis 27C gekennzeichnet. Ein Teil der Elektrodenschichten 27A, 27B, 27C ist dabei über eine Außenelektrode 28 mit der elektrischen Leitung 21 verbunden, wobei die Außenelektrode 28 an einer Außenseite 29 des Aktorkörpers 24 mit dem Aktorkörper 24 und in dem dargestellten Ausführungsbeispiel mit der Elektrodenschicht 27B verbunden ist. Ein anderer Teil der Elektrodenschichten 27A bis 27C ist über eine Außenelektrode 30 mit der elektrischen Leitung 22 verbunden, wobei die Außenelektrode 30 an einer Außenseite 31 des Aktorkörpers 24 mit dem Aktorkörper 24 sowie den Elektrodenschichten 27A, 27C verbunden ist.

Über die elektrischen Leitungen 21, 22 kann der Aktor 2 geladen werden, wobei sich dieser entlang der Achse 16 ausdehnt, so dass der zwischen dem Ventilschließkörper 13 und der Ventilsitzfläche 11 ausgebildete Dichtsitz geöffnet wird. Dadurch kommt es zum Abspritzen von Brennstoff aus dem Brennstoffraum 7 über einen Ringspalt 35 und den geöffneten Dichtsitz. Beim Entladen des Aktors 2 zieht sich dieser dann zusammen, so dass der zwischen dem Ventilschließkörper 13 und der Ventilsitzfläche 11 ausgebildete Dichtsitz wieder geschlossen ist.

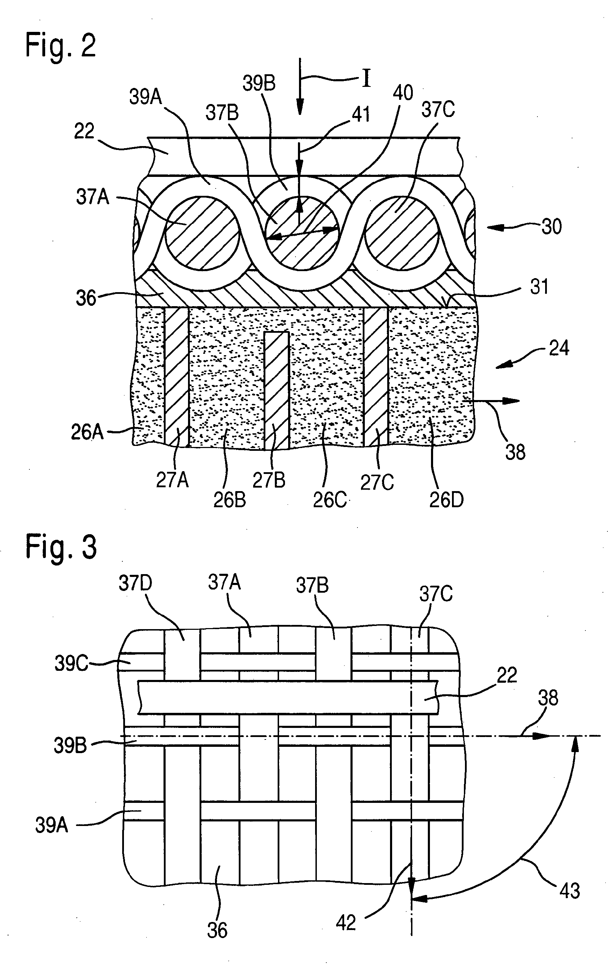

Die über die Außenelektrode 28 mit der elektrischen Leitung 21 verbundenen Elektrodenschichten 27B können beispielsweise die positiven Elektrodenschichten 27B bilden, während die mittels der Außenelektrode 30 mit der elektrischen Leitung 22 verbundenen Elektrodenschichten 27A, 27C die negativen Elektrodenschichten 27A, 27C bilden. Die Verbindung der Elektrodenschichten 27A, 27C mit der elektrischen Leitung 22 ist anhand der Fig. 2 und 3 im Detail weiter beschrieben. Die Verbindung der Elektrodenschichten 27B über die Außenelektrode 28 mit der elektrischen Leitung 21 kann auf entsprechende Weise erfolgen.

Fig. 2 zeigt den in Fig. 1 mit II bezeichneten Ausschnitt eines piezoelektrischen Aktors 2 eines Brennstoffeinspritzventils 1 in einer schematischen Schnittdarstellung. Der Aktorkörper 24 weist die Außenseite 31 auf, wobei sich die Elektrodenschichten 27A, 27C bis zu der Außenseite 31 erstrecken, während die Elektrodenschicht 27B etwas beabstandet zu der Außenseite 31 ausgestaltet ist. In Bezug auf die in der Fig. 1 dargestellte Außenseite 29 des Aktorkörpers 24, die der Außenseite 31 gegenüberliegt, erstreckt sich die Elektrodenschicht 27B bis zu der Außenseite 29, während die Elektrodenschichten 27A, 27C etwas beanstandet zu der Außenseite 29 ausgestaltet sind. Die Außenelektrode 30 ist mittels einer Verbindungsschicht 36 mit den Elektrodenschichten 27A, 27C verbunden, wobei die Verbindungsschicht 36 beispielsweise aus einem Lot ausgebildet ist, um die Außenelektrode 30 mit den Elektrodenschichten 27A, 27C zu verlöten. Die Außenelektrode 30 weist nebeneinander angeordnete und parallel zueinander verlaufende Schussdrähte 37A, 37B, 37C auf. Ferner weist die Außenelektrode 30 in einer Längsrichtung 38 des Aktorkörpers 24 verlaufende Längsdrähte 39A, 39B auf. Dabei verlaufen die Längsdrähte 39A, 39B nebeneinander und sind jeweils schlangenförmig ausgestaltet. Daher verläuft der Längsdraht 39A zunächst oberhalb des Schussdrahts 37A, dann unterhalb des Schussdrahts 37B und dann oberhalb des Schussdrahtes 37C. Der Längsdraht 39B, der neben dem Längsdraht 39A angeordnet ist, verläuft hingegen zunächst unterhalb des Schussdrahts 37A, dann oberhalb des Schussdrahts 37B und dann unterhalb des Schussdrahts 37C.

Ein Durchmesser 40 des Schussdrahts 37B ist größer gewählt als ein Durchmesser 41 des Längsdrahts 39A. In diesem Ausführungsbeispiel weisen alle Schussdrähte 37A, 37B, 37C zumindest in etwa den gleichen Durchmesser 40 auf. Die Längsdrähte 39A, 39B weisen ebenfalls den gleichen Durchmesser 41 auf, so dass sich ein mittlerer Durchmesser 41 der Längsdrähte 39A, 39B ergibt. Der mittlere Durchmesser 40 der Schussdrähte 37A bis 37C ist das x-fache des mittleren Durchmessers 41 der Längsdrähte 39A, 39B, wobei x größer als 1,0 und kleiner oder gleich 3 ist. Somit schlingen sich die relativ dünnen und flexiblen Längsdrähte 39A, 39B um die relativ steifen und im Wesentlichen geradeaus gestalteten Schussdrähte 37A bis 37C.

Die elektrische Leitung 22 ist auf geeignete Weise, insbesondere durch Löten oder Schweißen, mit der Außenelektrode 30, insbesondere den Schussdrähten 37A bis 37C und/oder den Längsdrähten 39A, 39B verbunden.

Fig. 3 zeigt eine auszugsweise Darstellung des piezoelektrischen Aktors 2 des Brennstoffeinspritzventils 1 des ersten Ausführungsbeispiels aus der in den Fig. 1 und 2 mit I bezeichneten Blickrichtung. Dabei ist ein weiterer Schussdraht 37D dargestellt, der neben dem Schussdraht 37A verläuft. Ferner ist ein weiterer Längsdraht 39C dargestellt, der neben dem Längsdraht 39B in der Längsrichtung 38 verläuft und der entsprechend dem Längsdraht 39A um die Schussdrähte 37A bis 37D geführt ist.

Der Schussdraht 37C verläuft in einer Querrichtung 42, die senkrecht zur Längsrichtung 38 orientiert ist, so dass die Querrichtung 42, in der der Schussdraht 37C verläuft, mit der Längsrichtung 38 einen Winkel 43 von 90° einschließt. Die Schussdrähte 37A, 37B, 37D verlaufen parallel zu dem Schussdraht 37C, so dass auch diese in der Querrichtung 42 verlaufen und somit senkrecht zu der Längsrichtung 38 orientiert sind. Im Betrieb des Brennstoffeinspritzventils 1 stimmt die Längsrichtung 38 des Aktorkörpers 24 mit einer Hubrichtung des Aktorkörpers 24 überein. Ferner ist die Längsrichtung 38 bei dem in der Fig. 1 dargestellten Brennstoffeinspritzventil 1 in Richtung der Achse 16 des Ventilgehäuses 3 orientiert.

Fig. 4 zeigt den in Fig. 3 dargestellten Ausschnitt eines piezoelektrischen Aktors 2 eines Brennstoffeinspritzventils 1 gemäß einem zweiten Ausführungsbeispiel der Erfindung. Dabei ist ein weiterer Schussdraht 37E dargestellt, der neben dem Schussdraht 37D angeordnet ist und parallel zu dem Schussdraht 37D verläuft.

Die Schussdrähte 37A bis 37E verlaufen parallel zueinander in einer Richtung 44, die verschieden zu der Querrichtung 42 ist, wodurch die Schussdrähte 37A bis 37E nur teilweise in der Querrichtung 42 verlaufen. Dabei schließt die Richtung 44, in der die Schussdrähte 37A bis 37E verlaufen, mit der Längsrichtung 38, in der die Längsdrähte 39A bis 39C verlaufen, einen Winkel 43 ein, der größer als 0° und kleiner als 90° ist.

Bei den in den Fig. 3 und 4 dargestellten Ausführungsbeispielen ist jeder der Schussdrähte 37A bis 37E so durch die Längsdrähte 39A, 39B, 39C geführt, dass von jeweils zwei der nebeneinander verlaufenden Längsdrähte 39A, 39B, 39C einer oberhalb und der andere unterhalb des jeweiligen Schussdrahtes 37A bis 37E verläuft. Die Schussdrähte 37A bis 37E sind als steife Schussdrähte ausgestaltet, wobei Werkstoffe wie Messing, Kupfer und/oder Silber zum Einsatz kommen können. Die Längsdrähte 39A bis 39C sind vorzugsweise flexibel ausgestaltet, wobei die Ausgestaltung aus einer Invarlegierung mit beispielsweise einem Anteil von 36 % Nickel vorteilhaft ist, um eine temperaturbedingte Ausdehnung der Längsdrähte 39A bis 39C beim Betrieb des Brennstoffeinspritzventils 1 zu vermeiden.

Die Erfindung ist nicht auf die beschriebenen Ausführungs-beispiele beschränkt.

## Patentansprüche

1. Piezoelektrischer Aktor (2), insbesondere Aktor für Brennstoffeinspritzventile, mit einem Aktorkörper (24), der eine Vielzahl von keramischen Schichten (26A - 26D) und eine Vielzahl von zwischen den keramischen Schichten (26A - 26D) angeordneten Elektrodenschichten (27A - 27C) aufweist, und zumindest einer Außenelektrode (30), die mit einem Teil der Elektrodenschichten (27A, 27C) verbunden ist, wobei
die Außenelektrode (30) mehrere zumindest im Wesentlichen in einer Längsrichtung (38) des Aktorkörpers (24) verlaufende Längsdrähte (39A - 39C) und mehrere Schussdrähte (37A - 37E) aufweist, wobei ein Schussdraht (37A - 37E) so durch die Längsdrähte (39A - 39C) geführt ist, dass ein Teil der Längsdrähte (39A - 39C) oberhalb und ein anderer Teil der Längsdrähte (39A - 39C) unterhalb des Schussdrahtes (37A - 37E) verläuft, **dadurch gekennzeichnet,**
**dass** der Schussdraht (37A - 37E) zumindest näherungsweise als gerader Schussdraht (37A - 37E) ausgebildet ist.

2. Piezoelektrischer Aktor nach Anspruch 1,
**dadurch gekennzeichnet,**
**dass** die Längsdrähte (39A - 39C) zumindest im Wesentlichen nebeneinander verlaufen und dass der Schussdraht (37A - 37E) so durch die Längsdrähte (39A - 39C) geführt ist, dass von jeweils zwei der nebeneinander verlaufenden Längsdrähte (39A - 39C) einer oberhalb und ein anderer unterhalb des Schussdrahtes (37A - 37E) verläuft.

3. Piezoelektrischer Aktor nach Anspruch 1 oder 2,
**dadurch gekennzeichnet,**
**dass** die Längsdrähte (39A - 39C) zumindest näherungsweise als schlangenförmige Längsdrähte (39A - 39C) ausgestaltet sind.

4. Piezoelektrischer Aktor nach einem der Ansprüche 1 bis 3,
**dadurch gekennzeichnet,**
**dass** die Schussdrähte (37A - 37E) zumindest im Wesentlichen parallel zueinander durch die Längsdrähte (39A - 39C) geführt sind und dass ein Längsdraht (39A - 39C) in der Längsrichtung (38) abwechselnd oberhalb eines der Schussdrähte (37A - 37E) und unterhalb eines der Schussdrähte (37A - 37E) verläuft.

5. Piezoelektrischer Aktor nach einem der Ansprüche 1 bis 4,
**dadurch gekennzeichnet,**
**dass** die Schussdrähte (37A - 37E) einen mittleren Durchmesser (40) aufweisen, der größer ist als ein mittlerer Durchmesser (41) der Längsdrähte (39A - 39C).

6. Piezoelektrischer Aktor nach Anspruch 5,
**dadurch gekennzeichnet,**
**dass** der mittlere Durchmesser (40) der Schussdrähte (37A - 37E) ein x-faches des mittleren Durchmessers (41) der Längsdrähte (39A - 39C) ist, wobei x größer als 1,0 und kleiner oder gleich 3 ist.

7. Piezoelektrischer Aktor nach einem der Ansprüche 1 bis 6,
**dadurch gekennzeichnet,**
**dass** die Längsdrähte (39A - 39C) als flexible Längsdrähte (39A - 39C) ausgebildet sind.

8. Piezoelektrischer Aktor nach Anspruch 7, dadurch gekennzeichent,
dass die Längsdrähte (39A - 39C) aus einem Werkstoff gebildet sind, der eine Invarlegierung aufweist.

9. Piezoelektrischer Aktor nach einem der Ansprüche 1 bis 8,
**dadurch gekennzeichnet,**
**dass** die Schussdrähte (37A - 37E) als steife Schussdrähte (37A - 37E) ausgestaltet sind.

10. Piezoelektrischer Aktor nach Anspruch 9,
**dadurch gekennzeichnet,**
**dass** die Schussdrähte (37A - 37E) aus einem Werkstoff gebildet sind, der Messing und/oder Kupfer und/oder Silber aufweist.

11. Piezoelektrischer Aktor nach einem der Ansprüche 1 bis 10,
**dadurch gekennzeichnet,**
**dass** die Schussdrähte (37A - 37E) in einer Querrichtung (42) des Aktorkörpers (24) verlaufen, wobei die Querrichtung (42) senkrecht zu der Längsrichtung (38) orientiert ist.

12. Piezoelektrischer Aktor nach einem der Ansprüche 1 bis 10,
**dadurch gekennzeichnet,**
**dass** die Schussdrähte (37A - 37E) in einer Richtung (44) verlaufen, die mit der Längsrichtung (38) einen Winkel (43) einschließt, der größer als 0° und kleiner als 90° ist.

13. Brennstoffeinspritzventil (1), insbesondere Injektor für Brennstoffeinspritzanlagen von luftverdichtenden, selbstzündenden Brennkraftmaschinen, mit einem piezoelektrischen Aktor (2) nach einem der Ansprüche 1 bis 12 und einem von dem Aktor (2) betätigbaren Ventilschließkörper (13), der mit einer Ventilsitzfläche (11) zu einem Dichtsitz zusammenwirkt.

## Claims

1. Piezoelectric actuator (2), in particular actuator for fuel injection valves, having an actuator body (24) which has a multiplicity of ceramic layers (26A-26D) and a multiplicity of electrode layers (27A-27C) arranged between the ceramic layers (26A-26D), and at least one external electrode (30) which is connected to a part of the electrode layers (27A, 27C), wherein the external electrode (30) has a plurality of longitudinal wires (39A-39C) extending at least substantially in a longitudinal direction (38) of the actuator body (24), and a plurality of weft wires (37A-37E), wherein a weft wire (37A-37E) is guided through the longitudinal wires (39A-39C) such that a part of the longitudinal wires (39A-39C) extends above the weft wire (37A-37E) and another part of the longitudinal wires (39A-39C) extends below the weft wire (37A-37E), **characterized in that** the weft wire (37A-37E) is formed at least approximately as a straight weft wire (37A-37E).

2. Piezoelectric actuator according to Claim 1, **characterized in that** the longitudinal wires (39A-39C) extend at least substantially alongside one another, and **in that** the weft wire (37A-37E) is guided through the longitudinal wires (39A-39C) such that, of in each case two of the longitudinal wires (39A-39C) extending alongside one another, one extends above the weft wire (37A-37E) and another below the weft wire (37A-37E).

3. Piezoelectric actuator according to Claim 1 or 2, **characterized in that** the longitudinal wires (39A-39C) are configured at least approximately as serpentine longitudinal wires (39A-39C).

4. Piezoelectric actuator according to one of Claims 1 to 3, **characterized in that** the weft wires (37A-37E) are guided at least substantially parallel to one another through the longitudinal wires (39A-39C), and **in that** a longitudinal wire (39A-39C) extends in the longitudinal direction (38) alternately above one of the weft wires (37A-37E) and below one of the weft wires (37A-37C).

5. Piezoelectric actuator according to one of Claims 1 to 4, **characterized in that** the weft wires (37A-37E) have an average diameter (40) which is greater than an average diameter (41) of the longitudinal wires (39A-39C).

6. Piezoelectric actuator according to Claim 5, **characterized in that** the average diameter (40) of the weft wires (37A-37E) is x times the average diameter (41) of the longitudinal wires (39A-39C), wherein x is greater than 1.0 and less than or equal to 3.

7. Piezoelectric actuator according to one of Claims 1 to 6, **characterized in that** the longitudinal wires (39A-39C) are in the form of flexible longitudinal wires (39A-39C).

8. Piezoelectric actuator according to Claim 7, **characterized in that** the longitudinal wires (39A-39C) are formed from a material which comprises an Invar alloy.

9. Piezoelectric actuator according to one of Claims 1 to 8, **characterized in that** the weft wires (37A-37E) are configured as rigid weft wires (37A-37E).

10. Piezoelectric actuator according to Claim 9, **characterized in that** the weft wires (37A-37E) are formed from a material which includes brass and/or copper and/or silver.

11. Piezoelectric actuator according to one of Claims 1 to 10, **characterized in that** the weft wires (37A-37E) extend in a transverse direction (42) of the actuator body (24), wherein the transverse direction (42) is oriented perpendicularly to the longitudinal direction (38).

12. Piezoelectric actuator according to one of Claims 1 to 10, **characterized in that** the weft wires (37A-37E) extend in a direction (44) which encloses an angle (43) of greater than 0° and less than 90° with the longitudinal direction (38).

13. Fuel injection valve (1), in particular injector for fuel injection systems of air-compressing, autoignition internal combustion engines, having a piezoelectric actuator (2) according to one of Claims 1 to 12 and a valve closing body (13) which is actuable by the actuator (2) and interacts with a valve seat surface (11) to form a sealing seat.

## Revendications

1. Actionneur piézoélectrique (2), en particulier actionneur pour des soupapes d'injection de carburant, comprenant un corps d'actionneur (24) qui présente une pluralité de couches céramiques (26A - 26D) et une pluralité de couches d'électrodes (27A - 27C) disposées entre les couches céramiques (26A - 26D), et au moins une électrode extérieure (30) qui est connectée à une partie des couches d'électrodes (27A - 27C), l'électrode extérieure (30) présentant plusieurs fils longitudinaux (39A - 39C) s'étendant essentiellement dans une direction longitudinale (38) du corps d'actionneur (24) et plusieurs fils de trame (37A - 37E), un fil de trame (37A - 37E) étant guidé à travers les fils longitudinaux (39A - 39C) de telle sorte qu'une partie des fils longitudinaux (39A - 39C) s'étende au-dessus du fil de trame (37A - 37E) et qu'une autre partie des fils longitudinaux (39A - 39C) s'étende en dessous du fil de trame (37A - 37E),
**caractérisé en ce que**
le fil de trame (37A - 37E) est réalisé au moins approximativement sous forme de fil de trame (37A - 37E) droit.

2. Actionneur piézoélectrique selon la revendication 1,
**caractérisé en ce que**
les fils longitudinaux (39A - 39C) s'étendent au moins essentiellement les uns à côté des autres et **en ce que** le fil de trame (37A - 37E) est guidé à travers les fils longitudinaux (39A - 39C) de telle sorte que sur deux des fils longitudinaux (39A - 39C) s'étendant à chaque fois l'un à côté de l'autre, l'un s'étend au-dessus du fil de trame (37A - 37E) et l'autre s'étend en dessous du fil de trame (37A - 37E).

3. Actionneur piézoélectrique selon la revendication 1 ou 2,
**caractérisé en ce que**
les fils longitudinaux (39A - 39C) sont configurés au moins approximativement sous forme de fils longitudinaux (39A - 39C) en forme de serpentin.

4. Actionneur piézoélectrique selon l'une quelconque des revendications 1 à 3,
**caractérisé en ce que**
les fils de trame (37A - 37E) sont guidés au moins essentiellement parallèlement les uns aux autres à travers les fils longitudinaux (39A - 39C) et **en ce qu'**un fil longitudinal (39A - 39C) s'étend dans la direction longitudinale (38) en alternance au-dessus d'un fil de trame (37A - 37E) et en dessous de l'un des fils de trame (37A - 37E).

5. Actionneur piézoélectrique selon l'une quelconque des revendications 1 à 4,
**caractérisé en ce que**
les fils de trame (37A - 37E) présentent un diamètre moyen (40) qui est supérieur à un diamètre moyen (41) des fils longitudinaux (39A - 39C).

6. Actionneur piézoélectrique selon la revendication 5,
**caractérisé en ce que**
le diamètre moyen (40) des fils de trame (37A - 37E) est un multiple x du diamètre moyen (41) des fils longitudinaux (39A - 39C), x étant supérieur à 1,0 et inférieur ou égal à 3.

7. Actionneur piézoélectrique selon l'une quelconque des revendications 1 à 6,
**caractérisé en ce que**
les fils longitudinaux (39A - 39C) sont réalisés sous forme de fils longitudinaux (39A - 39C).

8. Actionneur piézoélectrique selon la revendication 7, **caractérisé en ce que**
les fils longitudinaux (39A - 39C) sont formés en un matériau qui présente un alliage d'Invar.

9. Actionneur piézoélectrique selon l'une quelconque des revendications 1 à 8,
**caractérisé en ce que**
les fils de trame (37A - 37E) sont configurés sous forme de fils de trame (37A - 37E) rigides.

10. Actionneur piézoélectrique selon la revendication 9,
**caractérisé en ce que**
les fils de trame (37A - 37E) sont fabriqués en un matériau qui présente du laiton et/ou du cuivre et/ou de l'argent.

11. Actionneur piézoélectrique selon l'une quelconque des revendications 1 à 10,
**caractérisé en ce que**
les fils de trame (37A - 37E) s'étendent dans une direction transversale (42) du corps d'actionneur (24), la direction transversale (42) étant orientée perpendiculairement à la direction longitudinale (38).

12. Actionneur piézoélectrique selon l'une quelconque des revendications 1 à 10,
**caractérisé en ce que**
les fils de trame (37A - 37E) s'étendent dans une direction (44) qui forme avec la direction longitudinale (38) un angle (43) qui est supérieur à 0° et inférieur à 90°.

13. Soupape d'injection de carburant (1), en particulier injecteur pour installations d'injection de carburant de moteurs à combustion interne à compression d'air et auto-allumage, comprenant un actionneur piézoélectrique (2) selon l'une quelconque des revendications 1 à 12 et un corps de fermeture de soupape (13) pouvant être actionné par l'actionneur (2), lequel coopère avec une surface de siège de soupape (11) pour former un siège d'étanchéité.
